# FASCICULE DE BREVET EUROPEEN

(11) **EP 2 168 241 B1**
(45) Date de publication et mention de la délivrance du brevet: **21.09.2011**
(21) Numéro de dépôt: 08775102.0
(22) Date de dépôt: 15.07.2008
(51) Int. Cl.: H03K 17/76

(54) **DISPOSITIF DE COMMANDE POUR COMMUTATEURS INTÉGRÉS**
VORRICHTUNG ZUR STEUERUNG INTEGRIERTER SCHALTER
DEVICE FOR CONTROLLING INTEGRATED SWITCHES

(30) Priorité: 20.07.2007 FR 0705288
(43) Date de publication de la demande: 31.03.2010
(73) Titulaire: THALES, 92200 Neuilly-sur-Seine (FR)
(72) Inventeur: AURIC, Claude, F-78117 Chateaufort (FR); DUEME, Philippe, F-91400 Orsay (FR)
(74) Mandataire: Lucas, Laurent Jacques
(86) Numéro de dépôt international: PCT/EP2008/059245
(87) Numéro de publication internationale: WO 2009/013182

(56) Documents cités:
- EP-A- 0 794 613
- JP-A- 9 232 932
- KOBAYASHI K W ET AL: "A Monolithic HEMT-HBT Direct-Coupled Amplifier with Active Input Matching" IEEE MICROWAVE AND GUIDED WAVE LETTERS, IEEE INC, NEW YORK, US, vol. 6, no. 1, janvier 1996 (1996-01), XP011035023 ISSN: 1051-8207

## Description

L'invention concerne un dispositif de commande pour commutateurs intégrés comportant des cellules de commutation actives et passives.

Dans le cas de circuits réalisés en technologie MMIC (Monolithic Microwave Integrated Circuits, en langue anglaise), utilisant un matériau semi-conducteur de type dit « III-V » (le plus utilisé est l'Arséniure de Gallium, ou GaAs mais d'autres matériaux semi-conducteurs comme le Nitrure de Gallium (GaN) ou le Phosphure d'Indium (InP) peuvent être utilisés), les commutateurs sont réalisés à partir de transistors à effet de champ, désignés par l'acronyme TEC, dont le drain n'est pas polarisé par rapport à la source : on parle alors de TECs « froids », par opposition aux transistors polarisés entre drain et source, capables d'amplifier un signal qui sont alors qualifiés de TECs « chauds ».

Un TEC froid » peut être assimilé, en première approximation, à une résistance entre drain et source dont la valeur est commandée par une tension Vg appliquée entre grille et source ou entre grille et drain, le TEC pouvant être considéré comme symétrique. Toujours en première approximation, l'électrode de grille ne sert que comme électrode de commande et n'intervient pas directement dans le fonctionnement en hyperfréquence du circuit.

Pour une valeur que nous désignerons par « haute » de la tension de grille Vg, le TEC est passant, la résistance équivalente est de faible valeur. Pour une valeur que nous désignerons par « basse » de la tension de grille Vgs, le TEC est bloqué, la résistance équivalente est de forte valeur.

Les TECs froids sont ainsi insérés dans le circuit soit en série, soit en parallèle, soit selon une combinaison de transistors en série et en parallèle afin de réaliser la commutation souhaitée. Un élément de commutation réalisé par un TEC froid série sera à l'état bloqué quand le TEC est bloqué, à l'état passant quand le TEC est passant. Cette règle est inversée pour un élément de commutation réalisé par un TEC froid en parallèle (dont une des électrodes, drain ou source, est reliée à la masse).

Dans un élément de commutation actif une tension de polarisation Vds non nulle est appliquée entre le drain et la source d'un TEC. Une tension Vg de polarisation de la grille du TEC est utilisée comme signal de commande pour rendre ce transistor soit amplificateur soit bloqué, lui permettant de servir à la fois de composant amplificateur et de commutateur.

Pour les TECs les plus utilisés, cette tension Vg est légèrement négative, mais elle peut varier avec la technologie et le matériau semi-conducteur utilisés).

Pour un PHEMT (Pseudomorphic High Electron Mobility Transistors en langue anglaise), qui est n'est qu'un cas particulier des TECs, cette valeur de Vg est légèrement positive. Pour rendre un PHEMT amplificateur on applique une tension drain/source Vds positive et également une tension grille/source Vgs.

La tension grille/source Vgs à appliquer est assez précise et dépend des variations de procédé au cours de la fabrication des transistors sur une galette de matériau semi-conducteur, ou wafer en langue anglaise.

Pour bloquer un TEC, on applique une tension légèrement plus négative que la tension de pincement, sans arriver aux tensions de blocage des TECs Froids, une tension drain/source Vds étant appliquée sur le transistor on risquerait de dépasser la tension de claquage grille/drain Vgd et de le dégrader.

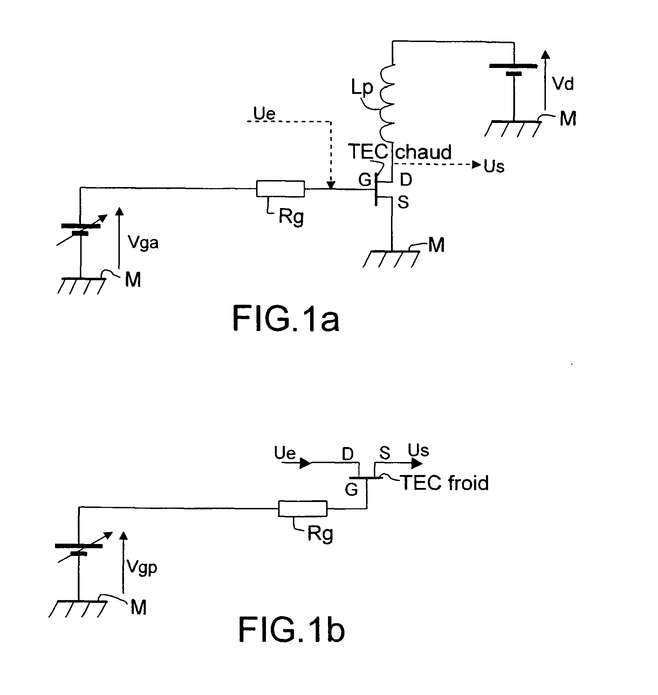

La figure 1 a montre un élément de commutation actif comportant un transistor à effet de champ TEC en montage amplificateur que nous désignerons par « TEC chaud ».

Selon une technique particulière de polarisation, le drain D du TEC chaud est polarisé à travers une self de découplage Lp par un potentiel Vd continu par rapport à un potentiel de référence, en l'occurrence une masse M. La grille G du TEC chaud est polarisée à travers une résistance Rg par une tension de polarisation Vga par rapport à la masse M. Cette tension de grille Vga est rendue variable de façon à commander le fonctionnement du TEC, soit pour le faire fonctionner en amplificateur haute fréquence, soit pour le mettre dans un état bloqué pour le dit signal haute fréquence.

Lorsqu'un signal d'entrée Ue haute fréquence est appliqué à la grille G:
- en fonctionnement en amplificateur, le transistor fourni sur le drain D un signal de sortie Us haute fréquence amplifiée ou peu atténué et,
- lorsque le transistor est à l'état bloqué le signal haute fréquence d'entrée Ue se trouve fortement atténué au niveau du drain D du transistor.
- le fonctionnement en amplificateur est obtenu pour des tensions Vga appliquées à la grille G comprises entre -0,4volt et 0 volt.
- l'état bloqué est obtenu pour des tensions Vga appliquées à la grille G comprises entre -1,5volt et -0,8 volts.

La figure 1b montre un élément de commutation passif comportant un transistor à effet de champ désigné par « TEC froid ». Dans ce montage, le signal haute fréquence d'entrée Ue est appliqué au drain D du transistor. Le signal de sortie Us se retrouve au niveau de la source S avec une atténuation variable en fonction de polarisation de grille Vg. Le transistor se comporte dans cette configuration comme une résistance variable entre drain D et source S en fonction de la tension de grille Vgp.

Dans les TEC, le drain D et la source S sont symétriques, la tension d'entrée Ue peut donc être appliquée à la source S et sortir par le drain D.

Pour aider la compréhension, on suppose par la suite que cet élément de commutation passif est un élément série, donc à l'état passant quand le TEC est passant. Dans la pratique, une voie de commutation 1 est très souvent associée à une voie de commutation 2 complémentaire, ce qui signifie que lorsque l'une est passante, l'autre est bloquée. Si dans une voie on utilise des éléments de commutation passifs en parallèle, pour lesquels la commande est « inversée », on utilisera la commande correspondant aux éléments série de la voie complémentaire.

Dans le montage de la figure 1b du TEC froid en commutateur passif,
- l'état passant est obtenu pour des tensions de grille Vgp comprises entre + 0,3volt et < 0.6volt volts ;
- l'état bloqué est obtenu pour des tensions de grille Vgp comprises entre -2 volts et -2,5 volts.

Toutes les valeurs de tension sont données à titre d'exemple pour la compréhension et sont valables uniquement pour des TECs de type dit « pseudomorphique » (acronyme PHEMT en anglais) mais le principe peut être appliqué à d'autres technologies. Par exemple, dans le cas du matériau GaN, les valeurs absolues des tensions seront nettement supérieures.

Dans le cas ou l'on utilise une combinaison d'éléments de commutation passifs et actifs pour réaliser une même fonction de commutation, on constate que les tensions de commandes Vgp, Vga à appliquer aux TECs froids et aux TECs chauds sont différentes. Pour effectuer une commutation il est alors nécessaire de changer les niveaux de deux tensions de commandes différentes de façon synchronisée.

Une solution simple consiste à amener les deux commandes séparées et synchronisées sur le circuit intégré avec l'inconvénient important de complexifier fortement les circuits de commandes à l'extérieur du composant.

Afin de pallier les inconvénients d'une commutation synchronisée d'éléments de commutation actifs et passifs, l'invention propose un dispositif de commutation intégré comportant au moins un élément de commutation actif ayant un transistor à effet de champ, dit transistor chaud, polarisé par une tension Vd appliquée entre le drain D et la source S et commandé par une première tension de polarisation appliquée à sa grille G pour rendre ce transistor chaud, soit amplificateur, soit bloqué, un l'élément de commutation passif ayant un transistor à effet de champ, dit transistor froid, commandé par une deuxième tension de polarisation appliquée à sa grille G pour rendre ce transistor froid soit passant soit bloqué,
caractérisé en ce qu'il comporte un circuit de commande des transistors chaud et froid comportant une source E1 de tension de polarisation connectée par un de ses pôles à un potentiel de référence, une source E2 de tension de commande connectée par un de ses pôles audit potentiel de référence les deux sources de tension E1, E2 étant reliées par leurs deux autres pôles libres par une résistance R en série avec une diode D1 dont la cathode est connectée au pôle libre de la source de tension de commande E2, la première tension de polarisation du transistor chaud étant fournie par le potentiel de l'anode de la diode D1, la deuxième tension de polarisation du transistor froid étant fournie par le potentiel de la cathode.

Avantageusement la tension de polarisation fournie par la source E1 de tension de polarisation est une tension continue.

Dans une réalisation, la tension de polarisation aux bornes de la source E1 de tension de polarisation est choisie de manière à polariser le transistor à effet de champ chaud dans un état amplificateur le courant dans sa grille G étant considéré comme nul.

La solution proposée consiste à générer sur le circuit intégré comportant un dispositif de commutation les première et deuxième tensions de polarisation respectivement des TECs froids et des TECs chauds synchronisés à partir d'une seule tension de commande amenée sur le circuit intégré. Cette tension de commande sera répartie sur les deux types de transistors TEC froid et TEC chaud au moyen d'un circuit simple faisant l'objet de l'invention.

L'invention sera mieux comprise à l'aide d'un exemple de réalisation d'un dispositif de commutation en référence aux dessins indexés dans lesquels :
- la figure 1a, déjà décrite, montre un élément de commutation actif ;
- la figure 1b, déjà décrite, montre un élément de commutation passif ;
- la figure 2 montre un exemple de réalisation d'un dispositif de commutation synchronisée, selon l'invention.

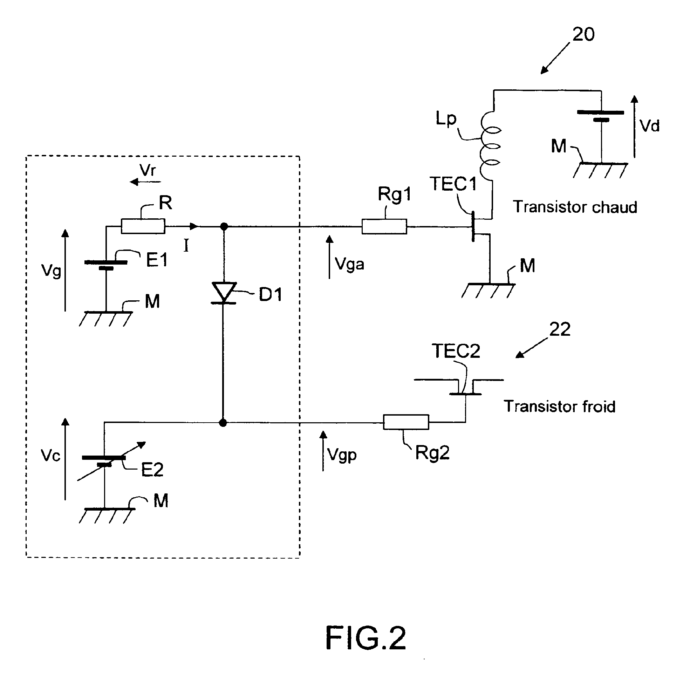

La figure 2 montre un exemple de réalisation d'un dispositif de commande synchronisée, selon l'invention, d'un élément de commutation actif 20 et d'un élément de commutation passif 22.

L'élément de commande actif 20 comporte un transistor TEC1 chaud dont le drain est polarisé, par exemple, à travers une self de découplage Lp par un potentiel Vd continu par rapport à un potentiel de référence, en l'occurrence une masse M.

Une résistance de découplage d'alimentation de grille Rg1 est connectée à la grille G du TEC1 chaud.

L'élément de commande passif 22 comporte un transistor TEC2 froid sans aucune polarisation entre le drain et la source. Une résistance de découplage d'alimentation de grille Rg2 est connectée à la grille G du TEC2 froid.

Ces résistances de découplage d'alimentation Rg1, Rg2 ne présentent pas de tension à ses bornes du fait que le courant de grille est négligeable, chacune des résistances Rg1, Rg2 peut être d'ailleurs remplacée ou complétée par une inductance.

Selon l'invention, le dispositif de commutation des éléments 20, 22 comporte une source de polarisation E1 fournissant une tension de polarisation continue Vg de l'élément de commande actif 20. Le pôle positif de la source de polarisation E1 est relié à une masse M du circuit et le pôle négatif à l'anode d'une diode D1 à travers une résistance R. La cathode de la diode D1 est reliée au pôle positif d'une source de commande E2 fournissant une tension de commande Vc du dispositif. L'autre pôle négatif de la source de commande E2 est relié à la masse.

L'anode de la diode D1 au potentiel Vga est reliée à la grille du transistor chaud TEC1 de l'élément de commande actif 20 à travers la résistance de découplage d'alimentation de grille Rg1 et la cathode de la diode D1 au potentiel Vgp est reliée à la grille du transistor froid TEC2 de l'élément de commande passif 22 à travers la résistance de découplage d'alimentation de grille Rg2.

Par la suite est expliqué le fonctionnement du dispositif de commande selon l'invention représenté à la figure 2.

Les tensions à appliquer (dans le cas d'un TEC sur GaAs) entre grille et source (Vgs) pour commander un transistor sont les mêmes que celle à appliquer aux TECs des figures 1 a et 1 b :
Tensions de commande Vgp pour TEC2 froid :
   - état passant : +0.3 < Vgp < 0.6V
   - état bloqué : -2 < Vgp < -2.5V
Tension de polarisation Vga de grille de l'amplificateur TEC1 chaud :
   - état amplificateur : -0.4 < Vga < 0
   - état bloqué : -1.5 < Vga < -0.8V

La tension de polarisation Vg aux bornes de la source de polarisation E1 est choisie de manière à polariser le TEC1 chaud en état amplificateur, le courant dans sa grille G étant considéré comme nul. Par exemple une tension de polarisation Vg = Vg1 est égale à -0.2volt.

Cette tension de polarisation Vg est à ajuster en fonction des variations durant le procédé de fabrication des plaques (ou wafer) comportant les TECs),

Dans un premier état du dispositif de commande :
La tension de commande Vc aux bornes de la source de commande E2 est une tension de commande Vc =Vc1 comprise entre 0,3V et 0,6V, la diode D1 est bloquée :
   - la tension de commande Vc1 = Vgp se trouve appliquée sur la grille du TEC2 froid. Le TEC2 froid se trouve à l'état passant et est alors équivalent à une résistance presque nulle entre le drain D et la source S.
   - la tension de polarisation Vga = Vg1 = -0,2V est appliquée à la grille G du TEC1 chaud. Le TEC1 chaud est dans l'état amplificateur et nous obtenons pour l'élément de commande actif 22 une fonction d'amplification.

Un signal haute fréquence pourra passer par le transistor amplificateur TEC1 chaud et en même temps par le transistor TEC2 froid.

Dans un deuxième état du dispositif de commande :
La tension de commande Vc aux bornes de la source de commande E2 est une tension de commande Vc =Vc2 comprise entre -2.5v et -2V, la diode D1 est rendue passante et un courant I s'établit dans la résistance R.
La tension de commande Vgp = Vc2 se retrouve sur la grille du TEC2 froid le mettant dans un état bloqué. Le TEC2 froid est équivalent à une résistance presque infinie.

La chute de tension Vr occasionnée par le courant I sans la résistance R permet de contrôler la tension Vga appliquée sur la grille du transistor TEC1 chaud, par exemple une tension Vga = -1,5Volts, le transistor TEC1 chaud est à l'état bloqué, en même temps que le transistor TEC2 froid.

La valeur de la résistance R est calculée à partir des tensions des sources E1 et E2 et de la tension Vga souhaitée sur la grille du transistor TEC1 chaud à l'état bloqué.

Le passage de la tension de commande Vc de la valeur de Vc1 à l'autre valeur Vc2 permet d'assurer la fonction de commutation de la manière voulue.

D'autres moyens de polarisation du TEC chaud sont utilisables par exemple, une « charge saturable ou « charge active », constituée d'un transistor fonctionnant en source de courant, peut remplacer la self de découplage Lp. On peut aussi utiliser la structure dite « autopolarisation » pour la grille : mettre la grille à la masse en courant continu à travers une résistance ou une self et insérer une résistance découplée (par un condensateur en parallèle) dans la source pour « remonter » le potentiel continu de source. Ce procédé permet d'économiser une source de tension de grille et de mieux stabiliser le dispositif en température. Dans notre application, il faudra commuter le potentiel de grille entre 0 et un potentiel « bloquant » ce qui revient à prendre Vga=0V pour l'état amplificateur.

Le dispositif de commande selon l'invention comporte des avantages :
- la commande du dispositif de commutation comportant des éléments de commande actifs et passifs n'a pas besoin d'une synchronisation des tensions de commande des éléments actifs et passifs ;
- la possibilité d'ajustage de la polarisation des transistors chauds ou amplificateurs est indépendante de la commutation ;
- le dispositif de commande est totalement compatible avec les tensions appliquées traditionnellement à un circuit composé de manière classique d'étages amplificateurs non commutés et d'éléments de commutation passifs à transistors froids.

## Revendications

1. Dispositif de commutation intégré comportant au moins un l'élément de commutation actif (20) ayant un transistor à effet de champ (TEC1), dit transistor chaud, polarisé par une tension Vd appliquée entre le drain D et la source S et commandé par une première tension de polarisation (Vga) appliquée à sa grille G pour rendre ce transistor chaud, soit amplificateur, soit bloqué, un l'élément de commutation passif (22) ayant un transistor à effet de champ (TEC2), dit transistor froid, commandé par une deuxième tension de polarisation (Vgp) appliquée à sa grille G pour rendre ce transistor froid soit passant soit bloqué,
**caractérisé en ce qu'**il comporte un circuit de commande des transistors chaud et froid comportant une source E1 de tension de polarisation (Vg) connectée par un de ses pôles à un potentiel de référence (M), une source E2 de tension de commande (Vc) connectée par un de ses pôles audit potentiel de référence (M) les deux sources de tension E1, E2 étant reliées par leurs deux autres pôles libres par une résistance R en série avec une diode D1 dont la cathode est connectée au pôle libre de la source de tension de commande E2, la première tension de polarisation (Vga) du transistor chaud (TEC1) étant fournie par le potentiel de l'anode de la diode D1, la deuxième tension de polarisation (Vgp) du transistor froid (TEC2) étant fournie par le potentiel de la cathode.

2. Dispositif de commutation selon la revendication 1, **caractérisé en ce que** la tension de polarisation (Vg) fournie par la source E1 de tension de polarisation est une tension continue.

3. Dispositif de commutation selon l'une des revendications 1 ou 2, **caractérisé en ce que** la tension de polarisation (Vg) aux bornes de la source E1 de tension de polarisation est choisie de manière à polariser le transistor à effet de champ chaud (TEC1) dans un état amplificateur, le courant dans sa grille G étant considéré comme nul.

4. Dispositif de commutation selon la revendication 3, **caractérisé en ce que** la tension de polarisation (Vg1) aux bornes de la source E1 de polarisation est égale à -0.2volt.

5. Dispositif de commutation selon la revendication 4, **caractérisé en ce que** dans un premier état du dispositif de commande la tension de commande (Vc) aux bornes de la source de commande E2 est une tension de commande (Vc =Vc1) comprise entre 0,3V et 0,6V, un signal haute fréquence pouvant passer par le transistor amplificateur (TEC1) chaud et en même temps par le transistor TEC2 froid.

6. Dispositif de commutation selon la revendication 4, **caractérisé en ce que** dans un deuxième état du dispositif de commande, la tension de commande (Vc) aux bornes de la source de commande E2 est une tension de commande (Vc =Vc2) comprise entre -2.5v et -2V, le transistor (TEC1) chaud étant à l'état bloqué, en même temps que le transistor (TEC2) froid.

7. Dispositif de commutation selon l'une des revendications 1 à 6, **caractérisé en ce que** la valeur de la résistance R est calculée à partir des tensions des sources E1 et E2 et de la tension (Vgp) souhaitée sur la grille du transistor (TEC1) chaud à l'état bloqué.

## Claims

1. An integrated switching device, comprising at least one active switching element (20) having a field effect transistor (TEC1), known as a hot transistor, biased by a voltage Vd applied between the drain D and the source S and controlled by a first bias voltage (Vga) applied to its gate G in order to place said hot transistor into either an amplifying or a blocked state, a passive switching element (22) having a field effect transistor (TEC2), known as a cold transistor, controlled by a second bias voltage (Vgp) applied to its gate G in order to place said cold transistor into either a transmitting or a blocked state,
**characterised in that** it comprises a circuit for controlling the hot and cold transistors comprising a source E1 of bias voltage (Vg) connected by one of its poles to a reference potential (M), a source E2 of control voltage (Vc) connected by one of its poles to said reference potential (M), the two voltage sources E1, E2 being connected by their two other free poles by a resistor R in series with a diode D1, the cathode of which is connected to the free pole of the source E2 of control voltage, the first bias voltage (Vga) of the hot transistor (TEC1) being provided by the potential of the anode of the diode D1, the second bias voltage (Vgp) of the cold transistor (TEC2) being provided by the potential of the cathode.

2. The switching device according to claim 1, **characterised in that** the bias voltage (Vg) provided by the source E1 of bias voltage is a direct voltage.

3. The switching device according to claim 1 or 2, **characterised in that** the bias voltage (Vg) at the terminals of the source E1 of bias voltage is selected so as to bias the hot field effect transistor (TEC1) in an amplifying state, the current in its gate G being considered zero.

4. The switching device according to claim 3, **characterised in that** the bias voltage (Vg1) at the terminals of the source E1 of bias is equal to -0.2 volts.

5. The switching device according to claim 4, **characterised in that** in a first state of the control device, the control voltage (Vc) at the terminals of the control source E2 is a control voltage (Vc = Vc1) of between 0.3V and 0.6V, a high signal frequency being able to pass via the hot amplifying transistor (TEC1) and the cold transistor TEC2 at the same time.

6. The switching device according to claim 4, **characterised in that** in a second state of the control device, the control voltage (Vc) at the terminals of the control source E2 is a control voltage (Vc = Vc2) of between -2.5V and -2V, the hot transistor (TEC1) being in the blocked state at the same time as the cold transistor (TEC2).

7. The switching device according to any one of claims 1 to 6, **characterised in that** the value of the resistor R is calculated from the voltages of the sources E1 and E2 and from the voltage (Vgp) required on the gate of the hot transistor (TEC1) in the blocked state.

## Patentansprüche

1. Integrierte Schaltvorrichtung, die Folgendes umfasst: wenigstens ein aktives Schaltelement (20) mit einem Feldeffekttransistor (TEC1), heißer Transistor genannt, der durch eine zwischen Drain D und Source S angelegte Spannung Vd vorgespannt und von einer ersten Vorspannung (Vga) gesteuert wird, die an sein Gate G angelegt wird, um den heißen Transistor in einen Verstärkungs- oder einen Sperrzustand zu setzen, ein passives Schaltelement (22) mit einem Feldeffekttransistor (TEC2), kalter Transistor genannt, der mit einer zweiten Vorspannung (Vgp) gesteuert wird, die an sein Gate G angelegt wird, um den kalten Transistor in einen Leitungs- oder einen Sperrzustand zu bringen,
**dadurch gekennzeichnet, dass** sie eine Schaltung zum Steuern des heißen und kalten Transistors umfasst, die eine Quelle E1 für eine Vorspannung (Vg), die durch einen ihrer Pole mit einem Bezugspotential (M) verbunden ist, und eine Quelle E2 für eine Steuerspannung (Vc) umfasst, die über einen ihrer Pole mit dem Bezugspotential (M) verbunden ist, wobei die beiden Spannungsquellen E1, E2 mit ihren zwei anderen freien Polen durch einen Widerstand R in Serie mit einer Diode D1 verbunden ist, deren Kathode mit dem freien Pol der Steuerspannungsquelle E2 verbunden ist, wobei die erste Vorspannung (Vga) des heißen Transistors (TEC1) vom Potential der Anode der Diode D1 bereitgestellt wird, wobei die zweite Vorspannung (Vgp) des kalten Transistors (TEC2) durch das Potential der Kathode bereitgestellt wird.

2. Schaltvorrichtung nach Anspruch 1, **dadurch gekennzeichnet, dass** die von der Vorspannungsquelle E1 bereitgestellte Vorspannung (Vg) eine Gleichspannung ist.

3. Schaltvorrichtung nach Anspruch 1 oder 2, **dadurch gekennzeichnet, dass** die Vorspannung (Vg) an den Anschlüssen der Vorspannungsquelle E1 so gewählt wird, dass der heiße Feldeffekttransistor (TEC1) in einen Verstärkungszustand vorgespannt wird, wobei der Strom an seinem Gate G als null angesehen wird.

4. Schaltvorrichtung nach Anspruch 3, **dadurch gekennzeichnet, dass** die Vorspannung (Vg1) an den Anschlüssen der Vorspannungsquelle E1 gleich -0,2 Volt ist.

5. Schaltvorrichtung nach Anspruch 4, **dadurch gekennzeichnet, dass** die Steuerspannung (Vc) an den Anschlüssen der Steuerquelle E2 in einem ersten Zustand der Steuervorrichtung eine Steuerspannung (Vc = Vc1) zwischen 0,3V und 0,6V ist, wobei eine hohe Signalfrequenz gleichzeitig durch den heißen Verstärkungstransistor (TEC1) und den kalten Transistor TEC2 passieren kann.

6. Schaltvorrichtung nach Anspruch 4, **dadurch gekennzeichnet, dass** die Steuerspannung (Vc) an den Anschlüssen der Steuerquelle E2 in einem zweiten Zustand der Steuervorrichtung ein Steuerspannung (Vc = Vc2) zwischen -2,5V und -2V ist, wobei der heiße Transistor (TEC1) zur selben Zeit im Sperrzustand ist wie der kalte Transistor (TEC2).

7. Schaltvorrichtung nach einem der Ansprüche 1 bis 6, **dadurch gekennzeichnet, dass** der Wert des Widerstands R von den Spannungen der Quellen E1 und E2 und von der Spannung (Vgp) berechnet wird, die am Gate des heißen Transistors (TEC1) im Sperrzustand benötigt wird.
